# EUROPÄISCHE PATENTANMELDUNG

(11) **EP 1 122 783 A2**
(43) Veröffentlichungstag der Anmeldung: **08.08.2001**
(21) Anmeldenummer: 01100984.2
(22) Anmeldetag: 17.01.2001
(51) Int. Cl.: H01L 23/498, H01L 23/48, H01L 23/14

(54) **Verfahren zum Herstellen eines Halbleiterbauelementes mit einem Silizium-Trägersubstrat**

(30) Priorität: 03.02.2000 DE 10004647
(71) Anmelder: Infineon Technologies AG, 81669 München (DE)
(72) Erfinder: Kröner, Friedrich, 9500 Villach (AT)
(74) Vertreter: Hermann, Uwe, Dipl.-Ing.

(57) **Zusammenfassung**

Auf der Mehrlagenverdrahtung eines Silizium-Trägersubstrats sind Halbleiterchips montiert, während die Unterseite des Trägersubstrats mit Lötkontakten in Form von Lotballungen (BGA) versehen und so strukturiert ist, dass für jeden Lötkontakt eine durch das Silizium-Trägersubstrat hindurchreichende Mulde gebildet ist, die von der jeweiligen Lotballung gefüllt ist, so dass die Lotballung selbst die Mehrlagenverdrahtung kontaktiert. Zumindest die Seitenwände der Mulde sind dabei mit einem isolierenden Material ausgekleidet. Die isolierende Schicht wird dabei vor dem Aufbringen der Mehrlagenverdrahtung auf das strukturierte Silizium-Trägersubstrat aufgebracht.

## Beschreibung

Die Erfindung betrifft ein Verfahren zum Herstellen eines Halbleiterbauelementes mit einem Multichipmodul und einem Silizium-Trägersubstrat.

Beim Aufbau komplexer elektronischer Systeme mit mehreren Halbleiterchips rücken im Zuge der Verringerung der Chipanschluß-Abstände zunehmend Probleme der Verbindungs- und Packaging-Technologie in den Vordergrund. Der konventionelle Aufbau, bei dem die Halbleiterchips individuell gehäust, mit Anschlüssen versehen und anschließend einzeln auf eine Leiterplatte bestückt werden, ist wegen des relativ hohen Platzbedarfs und wegen der erforderlichen Verdrahtung zwischen den einzelnen Chips in vielen Fällen nicht optimal.

Zunehmend üblich ist deshalb der Systemaufbau in Form von Multichipmodulen, bei denen ein Substrat mit einer hochdichten Mehrlagenverdrahtung, auf dem die Chips angebracht sind, als Zwischenträgersubstrat für eine gemeinsame Integration mehrerer Halbleiterchips in eine nächsthöhere Architekturebene des Systemaufbaus dient. Als Material für das Zwischenträgersubstrat kommen neben dem konventionellen Kunststoff heute vor allem Keramik, Metall und Silizium in Frage. Silizium und Keramik sind jedoch problematisch hinsichtlich der Kombination mit der platzsparenden Verbindungstechnik BGA (Ball Grid Array), da die erforderlichen Bohrungen für die Durchkontaktierung von der Mehrlagenverdrahtung auf der Bestückungsseite zu den flächig angeordneten Lotballungen auf der Unterseite beispielsweise für ein Keramiksubstrat nur schwer herstellbar sind.
Aus der nicht vorveröffentlichten DE 199 30 308.8 ist ein Multichipmodul bekannt mit einem Silizium-Trägersubstrat, auf dessen Bestückungsseite eine Mehrlagenverdrahtung aufgebracht ist, deren erste, oberste Leiterbahnebene mindestens einen, jeweils in Flip-Chip-Technik mittels Lotkügelchen montierten Halbleiterchip kontaktiert. Die Unterseite des Silizium-Trägersubstrats ist mit insbesondere flächig angeordneten Lötkontakten in Form von Lotballungen (BGA) versehen, die zur elektrischen Verbindung des Multichipmoduls mit einem Baugruppenträger dienen. Die Unterseite ist so strukturiert, dass für jeden Lötkontakt eine sich trichterförmig von der Unterseite bis zur untersten Leiterbahnebene verengende Mulde gebildet ist, die von der jeweiligen Lotballung gefüllt ist, so dass die Lotballung selbst die Mehrlagenverdrahtung kontaktiert.

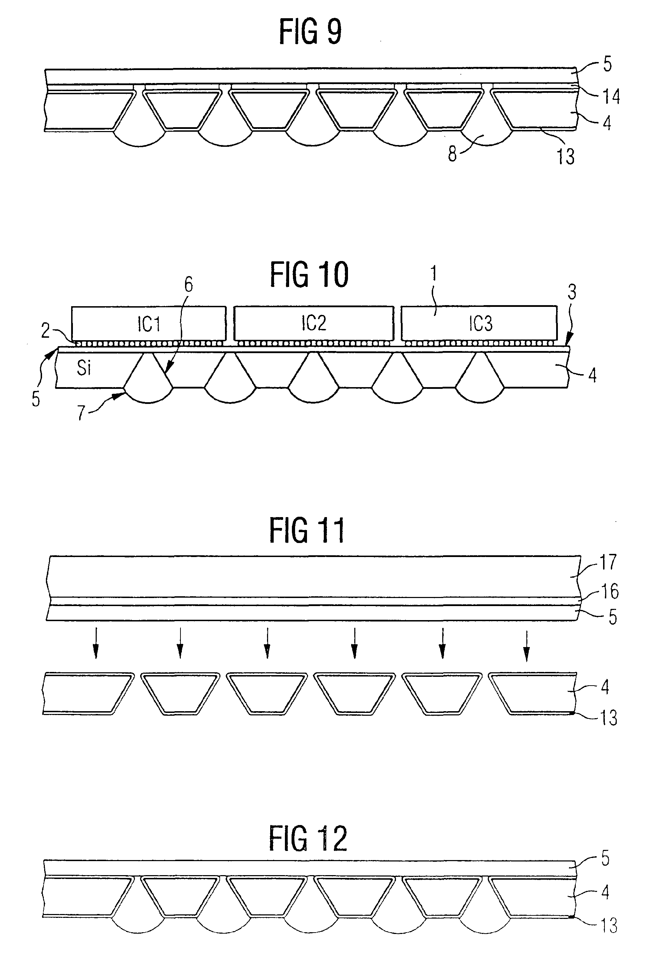

Figur 10 zeigt beispielsweise drei Halbleiterchips 1, die jeweils mit ihrer aktiven Seite mittels Lotkügelchen 2 auf der ersten, obersten Leiterbahnebene 3 des Silizium-Trägersubstrats 4 verlötet sind. Die Mehrlagenverdrahtung 5 ist in an sich bekannterweise als eine Sequenz von strukturierten Metallebenen, die durch ein organisches Dielektrikum elektrisch voneinander getrennt sind, ausgebildet. Dabei werden beispielsweise über lithographisch erzeugte via holes im Dielektrikum gezielt Verbindungen zwischen den Leiterbahnebenen hergestellt. Bevorzugt wird eine Mehrlagenverdrahtung mit alternierenden Cu-BCB-(Diphenylcyclobuthen)-Ebenen. Natürlich können außer den in Figur 10 dargestellten Halbleiterchips 1 auch weitere elektronische Bauelemente (in SMD-Technik) auf der Mehrlagenverdrahtung 5 verlötet werden. Die Mehrlagenverdrahtung 5 hat eine typische Dicke von ca. 50µm, während das eigentliche Silizium-Trägersubstrat 4 typischerweise einige 100*µ*m dick sein kann. Erkennbar in Figur 10 sind auch die in die trichterförmigen Mulden 6 eingefügten Lotballungen 7, die als Durchkontaktierung von der Mehrlagenverdrahtung 5 zur Unterseite des Halbleiterbauelementes dienen.

Die Fertigung eines derartigen Halbleiterbauelementes beginnt mit dem Aufbringen der Mehrlagenverdrahtung 5 auf das Silizium-Trägersubstrat 4. Im nächsten Fertigungsschritt werden die Lotkügelchen 2 auf die Mehrlagenverdrahtung 5 aufgebracht, vorzugsweise durch galvanisches Aufwachsen. Anschließend erfolgt die Strukturierung des Trägersubstrats 4, also Ausentwicklung und Tiefenätzen, beispielsweise mit dem flüssigen Ätzmittel KOH. Je nach Materialeigenschaften und Dicke des Trägersubstrats 4 läßt sich dabei ein gewünschter Winkel des Trichters in Trägersubstrat 4 relativ gut einstellen. Es resultieren dann die in Figur 10 dargestellten trichterförmigen Mulden 6, in die anschließend Lotballungen 7 mechanisch eingebracht werden, wobei durch die Mulden 6 eine größere Stabilität durch einen verbesserten Seitenhalt der Lotballungen 7 gegenüber den konventionellerweise nur mittels Pads befestigter Lotballungen resultiert. Dies ist hinsichtlich der bei thermischen Ausdehnungen auftretenden Scherkräfte vorteilhaft. In einem weiteren Fertigungsschritt werden schließlich die Halbleiterchips 1 auf die bereits vorhandenen Lotkügelchen 2 aufgelötet. Dies geschieht also durch Flip-Chip-Montage der Halbleiterchips 1 direkt auf das Trägersubstrat 4. Das resultierende Halbleiterbauelement kann mittels SMD-Montage über seine Lotballungen 7 in eine andere Baugruppe verlötet werden.

Aufgrund der mehr oder weniger großen Leitfähigkeit des Silizium-Trägersubstrates 4 ist es erforderlich, die Schrägseiten der strukturierten Mulden 6 (also nicht den Boden der Mulde 6, d.h. den Kontakt zur Mehrlagenverdrahtung 5) vor dem Einbringen der Lotballungen 7 mit einer Isolierschicht zu bedecken. Hierzu schlägt die DE 199 30 308.8 vor, die Schrägseiten der Mulden mittels eines schlecht planarisierenden Materials, beispielsweise Photoimid, auszukleiden. Ein gut planarisierendes Material würde demgegenüber unerwünschterweise nicht nur die Schrägseiten, also die innere Oberfläche des Trichters bedecken, sondern diesen ganz ausfüllen. Wird als Isolierschicht ein schlecht planarisierendes Material verwendet, so ist nicht mit ausreichender Sicherheit gewährleistet, dass nur die Schrägseiten mit diesem Material bedeckt sind. Es könnte deshalb zu fehlerhaften Verbindungen zwischen den Lotballungen und Mehrlagenverdrahtung 5 kommen.

Die Aufgabe der vorliegenden Erfindung besteht deshalb darin, ein Herstellungsverfahren für das vorstehend beschriebene Halbleiterbauelement anzugeben, bei dem auf einfache Weise eine sichere elektrische Verbindung zwischen der Mehrlagenverdrahtung und den Lotballungen hergestellt werden kann.

Diese Aufgabe wird mit den Merkmalen des Patentanspruches 1 gelöst.

Erfindungsgemäß sieht das Verfahren folgende Schritte vor:
a) Aufbringen der Isolierschicht auf das Silizium-Trägersubstrat
b) Aufbringen der Mehrlagenverdrahtung auf das Silizium-Trägersubstrat
c) Aufbringen der Lotballungen.

Dadurch, dass das strukturierte Silizium-Trägersubstrat, das bereits mit Mulden versehen ist, vor dem Verbinden mit der Mehrlagenverdrahtung mit der Isolierschicht versehen wird, sind wesentlich einfachere Verfahren möglich, um die Isolierschicht aufzubringen. Es ist dabei möglich, entweder vor oder nach dem Schritt c) auf die Mehrlagenverdrahtung zumindest einen Halbleiterchip aufzubringen und diesen mit der Mehrlagenverdrahtung elektrisch zu verbinden.

Vorteilhafte Ausgestaltungen ergeben sich aus den Unteransprüchen.

In einer vorteilhaften Ausgestaltung umfasst das Aufbringen der Isolierschicht folgende Schritte:
- Aufbringen einer gegenüber Siliziumätzen ätzresistenten Schicht zumindest auf der Seite der späteren Lotballungen der Silizium-Trägerschicht,
- fotolithographische Öffnung der ätzresistenten Schicht und Herstellen von durch die Silizium-Trägerschicht hindurchreichenden Mulden,
- Entfernen der ätzresistenten Schicht und
- Aufbringen einer Isolierschicht zumindest auf die Seitenwände der Mulden.

Vorteilhafterweise besteht die ätzresistente Schicht aus Silizium-Nitrit (Si₃N₄). Weiterhin ist es vorteilhaft, die ätzresistente Schicht auf beide Seiten der Silizium-Trägerschicht aufzubringen und die durch die Silizium-Trägerschicht hindurchreichenden Mulden durch Ätzen bis zum Erreichen der ätzresistenten Schicht herzustellen.

Die fotolithographische Öffnung der ätzresistenten Schicht findet dann auf der Seite der Silizium-Trägerschicht statt, die von den aufzubringenden Halbleiterchips abgewendet ist. Das Herstellen der Mulden (vertikale Verbindungen) kann beispielsweise mit heißer Kalilauge bis zum Erreichen der ätzresistenten Schicht durchgeführt werden, die sich auf der Seite der Trägerschicht befindet, auf der später die Halbleiterchips aufgebracht werden.

Die ätzresistente Schicht kann beispielsweise mit heißer Phosphorsäure entfernt werden, womit dann die Silizium-Trägerschicht mit den Mulden an den gewünschten Stellen vorliegt. Die Mulden können, wie einleitend beschrieben, mit schrägen Flanken oder aber mit Flanken orthogonal zu den Hauptflächen der Silizium-Trägerschicht ausgeführt sein.

Anschließend wird die isolierende Schicht auf die Trägerschicht aufgebracht, wobei dies in einer vorteilhaften Ausgestaltung durch Eintauchen der Trägerschicht in ein verflüssigbares und aushärtbares Material geschieht. Das Material könnte beispielsweise eine Keramikglasur oder ein Epoxydharz sein. Das verflüssigbare und aushärtbare Material muß dabei über Eigenschaften verfügen, so dass die Viskosität und somit die Schichtdicke derart einstellbar ist, dass die in die Trägerschicht eingebrachten Löcher nicht wieder verschlossen werden. Das Aushärten des Materials kann beispielsweise durch Verglasen mit einem Hochtemperaturprozeß realisiert werden.

In einer ersten Variante umfasst der Schritt des Aufbringens der Mehrlagenverdrahtung folgende Schritte:
- Aufbringen einer Folie auf das Silizium-Trägermaterial,
- Herstellen der Mehrlagenverdrahtung, beginnend mit einer Metallisierung und
- Entfernen der Folie an den Stellen der Lötkontakte von der Seite der Lotballung her.

Die Folie wird auf der Seite der Trägerschicht aufgebracht, auf der die Mehrlagenverdrahtung vorgesehen ist. Die Folie soll dabei möglichst dünn sein, aber derart aufgebracht werden, dass sie an den Stellen der Mulden in der Trägerschicht nicht "durchhängt". Auf die Folie wird die Mehrlagenverdrahtung aufgebracht. Die mit der Folie in Verbindung stehende Metallisierung muß geeignet sein, um mit dem später aufgebrachten Lotballen eine gute mechanische und elektrische Verbindung einzugehen. Die Folie kann an den Stellen der Lötkontakte beispielsweise durch Ätzung oder eine organische Lösung von der Seite des Silizium-Trägermaterials her, die von der Mehrlagenverdrahtung abgewandt ist, entfernt werden. Das Ätzmittel oder das Lösungsmittel darf dabei jedoch nur die Folie, nicht aber die in einem früheren Schritt aufgebrachte isolierende Schicht (z.B. Keramikglasur oder Epoxydharz) angreifen.

In einer anderen Alternative umfasst der Schritt des Aufbringens der Mehrlagenverdrahtung folgende Schritte:
- Herstellen der Mehrlagenverdrahtung auf einem Hilfssubstrat,
- Verbinden der Mehrlagenverdrahtung mit dem Silizium-Trägersubstrat und
- Entfernen des Hilfssubstrates.

Vorteilhafterweise wird zwischen der Mehrlagenverdrahtung und dem Hilfssubstrat eine Hilfsschicht vorgesehen, die nach dem Verbinden von der Mehrlagenverdrahtung und dem Silizium-Trägersubstrat entfernt wird. Die Hilfsschicht besteht hierzu vorteilhafterweise aus einem thermisch stabilen und unter Einwirkung eines Lösungsmittels auflösbaren Kunststoff. Der Kunststoff muß dabei alle Verfahrensschritte, die mit der Mehrlagenverdrahtung verbunden sind, thermisch ohne Beeinträchtigung aushalten. Unter Einwirkung eines Lösungsmittels soll er sich auflösen, wobei die Mehrlagenverdrahtung jedoch durch das Lösungsmittel nicht angegriffen werden darf. Allein durch das Auflösen der Hilfsschicht kann dann das Hilfssubstrat von der Mehrlagenverdrahtung des Halbleiterbauelementes abgelöst werden.

Die Erfindung und deren Vorteile werden anhand der nachfolgenden Ausführungsbeispiele näher erläutert. Es zeigen an:
- Figuren 1 bis 6: zeitlich hintereinander folgende Herstellungsschritte bis zum Aufbringen der isolierenden Schicht auf ein Silizium-Trägersubstrat,
- Figuren 7 bis 9: zeitlich aufeinander folgende Herstellungsschritte einer ersten Variante,
- Figur 10: ein aus dem Stand der Technik bekanntes Halbleiterbauelement und
- Figuren 11 und 12: die Herstellungsschritte einer zweiten Variante.

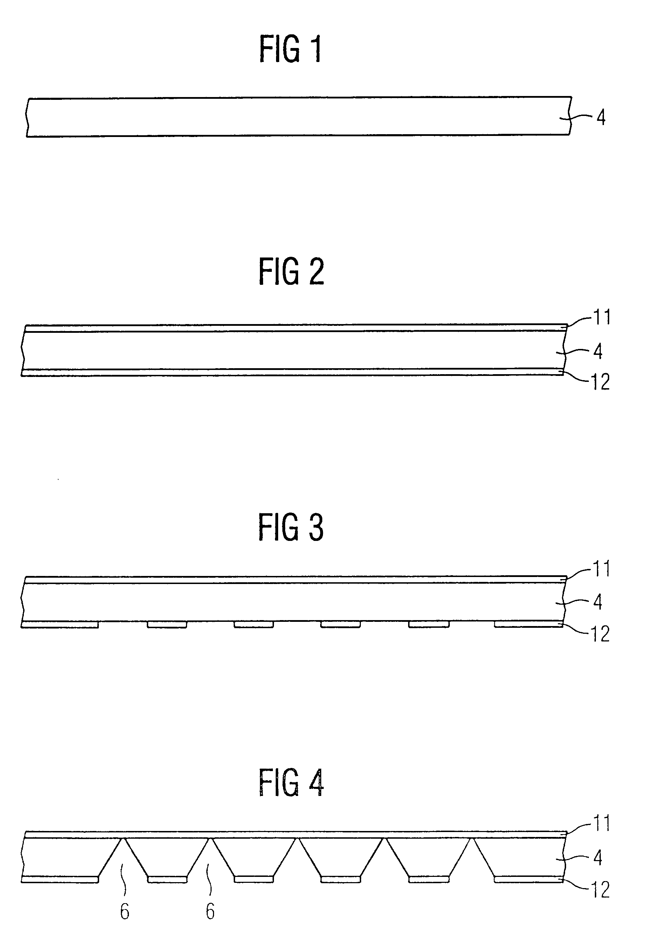

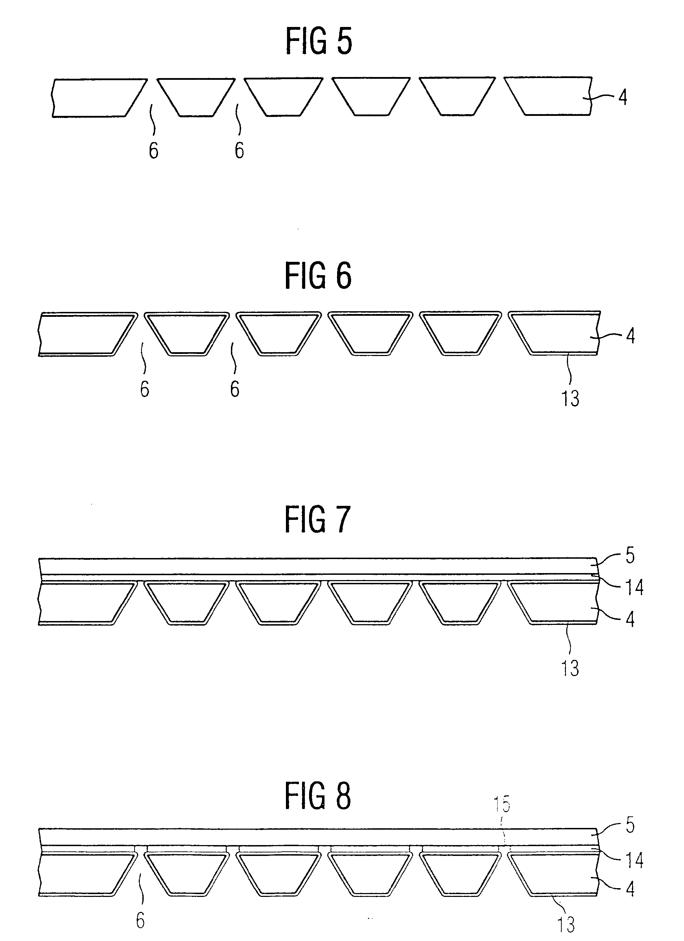

Die Figuren 1 bis 9 zeigen in zeitlich aufeinander folgenden Herstellungsschritten eine erste Variante des erfindungsgemäßen Verfahrens zur Herstellung eines Halbleiterbauelementes. In der Figur 1 ist ein Silizium-Trägersubstrat 4 dargestellt. Auf die beiden Hauptflächen der Silizium-Trägerschicht 4 wird jeweils eine ätzresistente Schicht 11, 12 aufgebracht (Figur 2). Auf der Hauptseite, auf der später die Lötkontakte vorgesehen sein sollen, wird die ätzresistente Schicht, im vorliegenden Beispiel die Schicht 12, fotomaskiert. Die ätzresistenten Schichten 11, 12 bestehen dabei bevorzugt aus Silizium-Nitrit. Nach dem Fotomaskieren werden Öffnungen vorzugsweise mit Plasmaätzung an den Stellen der späteren Lötkontakte in die ätzresistente Schicht 12 eingebracht (Figur 3). Anschließend werden die vertikalen Verbindungen (Mulden 6) in die Silizium-Trägerschicht geätzt. Die Mulden, die beispielsweise mit heißer Kalilauge hergestellt werden können, werden bis zum Erreichen der ätzresistenten Schicht 11 in die Trägerschicht 4 eingebracht. Auf der Hauptseite, auf der die ätzresistente Schicht 11 aufgebracht ist, werden später Halbleiterchips aufgebracht. In der Figur 4 weisen die Mulden 6 schräge Flanken (Seitenwände) auf. Selbstverständlich wäre es auch denkbar, zylindrische Ausnehmungen in der Trägerschicht 4 vorzusehen. In einem nächsten Verfahrensschritt, der in der Figur 5 dargestellt ist, wird auf beiden Hauptseiten der Trägerschicht 4 die ätzresistenten Schichten 11, 12 entfernt.

In diesem Zustand liegt somit nur noch Silizium-Trägerschicht 4 mit den Mulden 6 vor.

Anschließend wird eine isolierende Schicht, z.B. aus einer Keramikglasur oder einem Epoxydharz aufgebracht. Dieses geschieht vorteilhafterweise mittels eines Tauchvorganges, so dass die gesamte Oberfläche der Trägerschicht 4 von der isolierenden Schicht 13 bedeckt ist. Über die Viskosität der isolierenden Schicht ist deren Schichtdicke derart einzustellen, dass die in der Trägerschicht 4 befindlichen durchgehenden Mulden nicht wieder verschlossen werden.

Im nächsten Verfahrensschritt wird auf der von den späteren Lötballungen abgewandten Seite der Trägerschicht 4 eine Folie 14 aufgebracht, auf die dann eine Mehrlagenverdrahtung 5 aufgebaut wird. Die erste Sequenz der Mehrlagenverdrahtung beinhaltet dabei eine Metallisierung, die in unmittelbarer Verbindung mit der Folie 14 steht. Vorzugsweise werden auf dem Silizium-Trägersubstrat 4 vier Leiterbahnebenen aufgebracht. Die Mulden 6 sind zur Aufnahme von Lötballungen vorgesehen. Um eine elektrische Verbindung zwischen diesen und der ersten Metallisierung der Mehrlagenverdrahtung 5 ermöglichen zu können, wird die Folie 14 von der Seite der späteren Lötballungen her entfernt. Das Entfernen kann beispielsweise durch eine Ätzung oder eine organische Lösung stattfinden. Dieser Fertigungsschritt ist in der Figur 8 dargestellt. Die Figur 9 zeigt dann bereits die in die Mulden 6 eingebrachten Lötballungen 8. Vor oder nach dem Aufbringen der Lötballungen 8 kann auf der Mehrlagenverdrahtung 5 zumindest ein Halbleiterchip (nicht gezeigt) aufgebracht werden. Dieser kann beispielsweise, wie in Figur 10 gezeigt, über eine Flip-Chip-Kontaktierung oder über eine gewöhnliche Bond-Verdrahtung mit einer Metallisierung der Mehrlagenverdrahtung elektrisch verbunden sein.

Die Figuren 11 und 12 zeigen eine alternative Variante, um die Mehrlagenverdrahtung 5 mit der bereits mit der isolierenden Schicht 13 versehenen Trägerschicht 4 zu verbinden. Die Mehrlagenverdrahtung 5 ist hierzu über eine Hilfsschicht 16 mit einem Hilfssubstrat 17, z.B. einem Halbleiterwafer, verbunden worden. Das Hilfssubstrat 17 dient lediglich als Hilfsträger, um die Mehrlagenverdrahtung 5 erzeugen zu können. Anschließend wird dieser Verbund mit der Silizium-Trägerschicht 4 verbunden. Dies ist z.B. mit einem Schmelzkleber möglich, dessen Erweichungspunkt höher als die Temperatur liegt, mit der sich die Hilfsschicht 16 löst. Derartige Systeme sind von doppelseitig klebenden Folien für die Technologie von Trägerwafern her bekannt. Ein alternativer Stoff zur Bewerkstelligung der Verbindung sind sehr niedrig erweichende Fluo-Phosphatgläser. Die Hilfsstruktur 17 kann entweder durch ein Auflösen der Hilfsschicht 16 oder ein nasschemisches Ätzen sowohl der Hilfsschicht als auch des Hilfssubstrat 17 erfolgen.

Die getrennte Herstellung des Trägersubstrates und der Mehrlagenverdrahtung und die anschließende Verbindung dieser beiden Bauelemente ermöglicht ein besonders einfaches und zeitsparendes Herstellungsverfahren für ein Halbleiterbauelement mit einer mehrlagigen Dünnfilmstruktur.

## Patentansprüche

1. Verfahren zum Herstellen eines Halbleiterbauelementes, das ein Multichipmodul aufweist
- mit einem Silizium-Trägersubstrat (4),
- auf dessen Bestückungsseite eine Mehrlagenverdrahtung (5) aufgebracht ist,
- deren erste, oberste Leiterbahnebene (3) mindestens einen Halbleiterchip (1) kontaktiert,
- und bei dem die Unterseite des Silizium-Trägersubstrats (4) mit Lötkontakten in Form von Lotballungen (7) (BGA) versehen ist, die zur elektrischen Verbindung des Multichipmoduls mit einem Baugruppenträger dienen, wobei die Lotballungen (7) selbst durch Mulden (6) hindurch die Mehrlagenverdrahtung (5) kontaktieren,
- bei dem die Seiten der Mulden (6) jeweils mit einer Isolierschicht (13) bedeckt sind,
mit folgenden Schritten:
a) Aufbringen der Isolierschicht (13) auf die Seiten der Mulden des Silizium-Trägersubstrats (4)
b) Aufbringen der Mehrlagenverdrahtung (5) auf die Bestückungsseite des Silizium-Trägersubstrats (4)
c) Aufbringen der Lotballungen (7).

2. Verfahren nach Anspruch 1,
**dadurch gekennzeichnet,** daß
vor oder nach dem Schritt c) auf die Mehrlagenverdrahtung (5) zumindest ein Halbleiterchip aufgebracht und mit dieser elektrisch verbunden wird.

3. Verfahren nach Anspruch 1 oder 2,
**dadurch gekennzeichnet,** daß
das Aufbringen der Isolierschicht (13) umfasst:
- Aufbringen einer gegenüber Siliziumätzen ätzresistenten Schicht (11) zumindest auf der Seite der späteren Lotballungen (7) der Silizium-Trägerschicht (4),
- Fotomaskierung der ätzresistenten Schicht (11) und Herstellen von durch die Silizium-Trägerschicht (4) hindurch reichenden Mulden (6),
- Entfernen der ätzresistenten Schicht (11),
- Aufbringen einer Isolierschicht (13) zumindest auf die Seitenwände der Mulden (6).

4. Verfahren nach Anspruch 3,
**dadurch gekennzeichnet,** daß
die ätzresistente Schicht (11) Si₃N₄ ist.

5. Verfahren nach Anspruch 3 oder 4,
**dadurch gekennzeichnet,** daß
die ätzresistente Schicht (11) auf beide Seiten der Silizium-Trägerschicht (4) aufgebracht wird und die durch die Silizium-Trägerschicht (4) hindurch reichenden Mulden (6) durch Ätzen bis zum Erreichen der ätzresistenten Schicht (11) hergestellt werden.

6. Verfahren nach einem der Ansprüche 3 bis 5,
**dadurch gekennzeichnet,** daß
das Aufbringen der isolierenden Schicht (13) durch Tauchen der Silizium-Trägerschicht (4) in ein verflüssigbares und aushärtbares Material vorgenommen wird.

7. Verfahren nach Anspruch 6,
**dadurch gekennzeichnet,** daß
die isolierende Schicht (13) aus einer Keramikglasur oder Epoxydharz besteht.

8. Verfahren nach einem der Ansprüche 1 bis 7,
**dadurch gekennzeichnet,** daß
der Schritt des Aufbringens der Mehrlagenverdrahtung (5) umfasst:
- Aufbringen einer Folie (14) auf das Silizium-Trägermaterial (4),
- Herstellen der Mehrlagenverdrahtung (5), beginnend mit einer Metallisierung,
- Entfernen der Folie (14) an den Stellen, an denen die Lotballungen (7) die Mehrlagenverdrahtung (5) kontaktieren sollen.

9. Verfahren nach einem der Ansprüche 1 bis 7,
**dadurch gekennzeichnet,** daß
der Schritt des Aufbringens der Mehrlagenverdrahtung (5) umfasst :
- Herstellen der Mehrlagenverdrahtung (5) auf einem Hilfssubstrat (17),
- Verbinden der Mehrlagenverdrahtung (5) mit dem Silizium-Trägersubstrat (4),
- Entfernen des Hilfssubstrates (17).

10. Verfahren nach Anspruch 9,
**dadurch gekennzeichnet,** daß
zwischen der Mehrlagenverdrahtung (5) und dem Hilfssubstrat (17) eine Hilfsschicht (16) vorgesehen ist, die nach dem Verbinden der Mehrlagenverdrahtung (5) mit dem Silizium-Trägersubstrat (4) entfernt wird.

11. Verfahren nach Anspruch 9 oder 10,
**dadurch gekennzeichnet,** daß
die Hilfsschicht (16) aus einem thermisch stabilen und unter Einwirkung eines Lösungsmittel auflösbaren Kunststoff besteht.
